(19) Europäisches Patentamt
European Patent Office
Office européen des brevets

(11) Publication number : **0 538 923 A2**

# (12) EUROPEAN PATENT APPLICATION

(21) Application number : **92202976.4**

(22) Date of filing : **29.09.92**

(51) Int. Cl.[5] : **D01F 6/88,** D01F 6/70, D01F 6/92

(30) Priority : **03.10.91 BE 9100908**

(43) Date of publication of application : **28.04.93 Bulletin 93/17**

(84) Designated Contracting States : **AT BE CH DE DK ES FR GB IT LI NL SE**

(71) Applicant : **DSM N.V.**
**Het Overloon 1**
**NL-6411 TE Heerlen (NL)**

(72) Inventor : **Greidanus, Pieter Jan**
**van Goghlaan 17**
**NL-6006 Weert (NL)**
Inventor : **de Koning, Adrianus Johannes**
**Wijnmanlaan 28**
**NL-8014 KA Zwolle (NL)**
Inventor : **Bastiaansen, Cornelis Wilhelmus Maria**
**Heerderweg 64 N**
**NL-6224 LH Maastricht (NL)**

## (54) Process for the preparation of a thermosetting elongated object.

(57) The invention relates to a process for the preparation of a thermosetting elongated object by at least partly polymerizing a mixture of precursors for thermosetting resins and subsequently spinning and finally crosslinking the mixture, in which process successively :

i) a mixture is composed that consists of

1) a first monomer possessing a number of functional groups of which one part falls in a first category and another part falls in a second category, a functional group of the first category not reacting with a functional group of the second category, and the monomer being essentially di-functional as regards the first category,

2) a second monomer possessing essentially two functional groups that fall in the first category,

3) a third monomer possessing one or more functional groups with a divalent functionality that fall in the second category ;

ii) the first monomer is reacted with the second monomer, yielding a virtually linear polymer ;

iii) the mixture is spun into an elongated object ;

iv) the virtually linear polymer is reacted with the third monomer.

EP 0 538 923 A2

The invention relates to a process for the preparation of a thermosetting elongated object by at least partly polymerizing a mixture of precursors for thermosetting resins and subsequently spinning and finally crosslinking the mixture.

Such a process is known from EP-A-243,775, in which a polyurethane is spun into fibres after which a certain degree of crosslinking is effected by means of β or γ radiation in the presence of acrylate. The result is a rubber-like fibre.

The drawback of such a process is that the mechanical and thermal properties of the fibre produced are insufficient.

The object of the invention is to provide a process not having the said drawback.

According to the invention this is achieved in that, successively:

i) a mixture is composed that consists of

1) a first monomer possessing a number of functional groups of which one part falls in a first category and another part falls in a second category, a functional group of the first category not reacting with a functional group of the second category, and the monomer being essentially di-functional as regards the first category,

2) a second monomer possessing essentially two functional groups that fall in the first category,

3) a third monomer possessing one or more functional groups with a divalent functionality that fall in the second category;

ii) the first monomer is reacted with the second monomer, yielding a virtually linear polymer;

iii) the mixture is spun into an elongated object;

iv) the virtually linear polymer is reacted with the third monomer.

The invention therefore comprises the reacting of several components by at least two categories of reactions, the reactions of the two categories being separated in time. In the phase between the two reactions the mixture then is spun. In most cases it is not possible to spin the mixture before a reaction has taken place, the mixture then being too thinly (Newtonian) liquid. After both reactions have taken place spinning of the mixture is not possible, either, for then a three-dimensional network has been formed.

The virtually linear polymer resulting from step ii has thermoplastic properties.

From US-A-4,298,682 it is known to use a monomer mixture comparable to the mixture used in the present invention for the preparation of the moulded, often fiber reinforced, articles. In a special embodiment a partial polymerisation of the mixture is applied to prevent the sagging of the reinforcing fibers. This embodiment and essentially the subject matter of the patent is totally unrelated with the spinning of fibers or any related technique.

In the framework of this invention a monomer is understood to mean a molecule that is capable of polymerization and that does not yet have a high molecular weight. Normal, in contrast to high, molecular weights range from some dozens to some thousands of Daltons. Molecules already built up of various building blocks and customarily denoted as oligomers are included.

Dalton is the unit of molecular weight, its dimension being g/mol.

Where a monomer is referred to in the framework of this invention, this is understood to include a mixture of various different monomers fitting the same description.

In the framework of this invention a functional group is understood to be a group capable of reacting with a group from another molecule and of forming a covalent bond therewith. Two functional groups that can together form a bond may be two different groups or two identical groups. Examples of two identical groups are two ethylenic unsaturations forming a bond in a radical reaction. Examples of two different groups are an isocyanate and an hydroxyl group or an epoxy group and an acid group. In the last case the two functional groups are called complementary.

In the framework of the invention a category is understood to mean a collection of functional groups capable of reacting with each other via a certain reaction mechanism. Examples of categories are:

- isocyanates with hydroxyl groups
- isocyanates with amines
- isocyanates with epoxies
- epoxies with acids
- acids or acid anhydrides with alcohols
- oxazolines with acids or acid anhydrides
- two ethylenic unsaturations.

A certain reaction in a category has a temperature range within which the reaction will proceed at a certain velocity. On the cold side of this range the reaction will need to be stimulated, for instance by means of a catalyst. On the warm side the reaction may optionally be inhibited, for instance by means of an inhibitor. If two categories of reactions are temperature sensitive, they may if necessary be separated by accelerating the one

and slowing down the other. The possibility of largely, i.e. in a practically feasible manner, separating the reactions of the two categories in time is a condition for applicability in a process according to the invention.

The above remarks on the temperature can be applied also to other process parameters such as lighting (intensity, wavelength), concentration, pressure, etc.

In the framework of this invention reacting is understood to mean the formation of a covalent chemical bond.

In the framework of this invention functionality is understood to mean the number of possibilities of forming a chemical bond within a certain category. A monoethylenically unsaturated dicarboxylic acid, for instance, has a functionality of two as regards the acid groups, and a functionality of two also as regards the ethylenic unsaturation. In a radical polymerization an ethylenic unsaturation can be regarded as a bi-radical. One ethylenic unsaturation can yield a covalent bond in two directions.

When mention is made of an essentially di-functional monomer in the framework of the invention, this means that most monomers have a functionality of two, but that it is possible for a small percentage with a higher or lower functionality to be present.

The mixture may contain a small amount of tri- or higher-functional monomers, which ensures that the polymers are branched. This may be advantageous for effecting a faster increase in the degree of polymerization of the polymer. This may for instance be 1-5 wt.% relative to the mixture.

The first monomer has an average functionality in the second category of at least one and preferably at least two.

The second monomer is di-functional in the first category and may in addition have a certain functionality in the second category. Preferably the two functional groups of the second monomer in the first category are complementary with the two functional groups of the first monomer in the first category.

The third monomer is polyfunctional in the second category, but may in addition have functional groups that fall in the first category. Preferably, however, this third monomer does not have any functional groups that fall in the first category.

An elongated object in this invention is understood to mean a fibre, film, tube and any other possible virtually endless object.

Spinning in this invention means deforming a mass in such a manner that it becomes endless in at least one dimension. This may be the well-known spinning using a spinneret, but also extrusion from an extruder or rolling between two rolls.

As criterion for the spinnability use can be made of the criterion as defined by Ziabicki in "Fundamentals of Fibre Formation", J. Wiley & Sons Ltd, London, 1976 (herewith included as reference):

'A liquid is spinnable under the given conditions if a steady-state, continuous elongation of the fluid jet proceeds without a break of any kind'.

"The given conditions" here means the conditions optimized by one skilled in the art.

A first example of a system that can be used according to the invention is a mixture consisting of

1) a diol with at least one ethylenic unsaturation
2) a polyisocyanate, and
3) an ethylenically unsaturated monomer.

The polyisocyanate on average contains about 2 isocyanate groups per molecule. The diisocyanate may for instance be chosen from aliphatic, cycloaliphatic or aromatic isocyanates such as toluene diisocyanates, 1-5-naphthalene diisocyanate, cumene-2,4-diisocyanate, methylene-4,4′-diphenyl-diisocyanate, methylene dicyclohexyl-4,4′-diisocyanate, 4-methoxy-1,3-phenylene diisocyanate, 4-chloro-1,3-phenylene diisocyanate, 4-bromo-1,3-phenylene diisocyanate, 4-ethoxy-1,3-phenylene diisocyanate, 2,4′-diisocyanato diphenyl ether, 5,6-dimethyl-1,3-phenylene diisocyanate, 2,4-dimethyl-1,3-phenylene diisocyanate, 4,4′-diisocyanate diphenyl ether, benzidine diisocyanate, 4,6-dimethyl-1,3-phenylene diisocyanate, durene diisocyanate, 4,4′-diisocyanate dibenzyl, 3,3′-dimethyl-4,4′-diisocyanate diphenyl, 2,4-diisocyanate stilbene, 3,3′-dimethoxy-4,4′-diisocyanate phenyl methane, 3,3′-dimethoxy-4,4′-diisocyanate diphenyl, 1,4-anthracene diisocyanate, 2,5-fluorene diisocyanate, 1,8-naphthalene diisocyanate, 2,6-diisocyanato benzofuran, amyl benzene-2,4-diisocyanate, hexyl benzene-2,4-diisocyanate, dodecyl benzene-2,4-diisocyanate, butyl benzene-2,4-diisocyanate.

The diol may be chosen from all possible compounds with about 2 hydroxyl groups per molecule and at least one ethylenic unsaturation. These may be aliphatic, cycloaliphatic or aromatic compounds, whether substituted or not. The diol may have a molecular weight from 100 to 5000 Dalton, and it preferably has a molecular weight of 300 to 3000 Dalton. The diol may consist of a diester of an unsaturated dicarboxylic acid or dicarboxylic acid anhydride with 2 diols.

As alcohol use may be made of an alkoxylated bisphenol, such as, for instance, ethoxylated or propoxylated bisphenol A. An alkoxylated bisphenol is here understood to mean a compound of the following formula I, in which $R_1$ and $R_2$ are chosen from hydrogen atoms and hydrocarbon residues, preferably from alkyl groups,

in particular methyl.

$$
\begin{array}{l}
H-(-O-\underset{R_1}{\underset{|}{CH}}-\underset{R_2}{\underset{|}{CH}}-)_n-O- \quad O \quad -X- \quad O \quad -O-(-\underset{R_1}{\underset{|}{CH}}-\underset{R_2}{\underset{|}{CH}}-O-)_m-H \qquad I
\end{array}
$$

The value of n+m is normally below 12 for the invention. Preferably n and m both have an average value of about 1. X represents a $-CH_2-$, $-C(CH_3)_2-$, $-SO_2-$ or -O- bond.
Optionally, one or both of the aromatic groups in the diol of formula I may be fully hydrogenated.

Use is made in particular of alkoxylated bisphenol A, and more in particular of ethoxylated bisphenol A.

It is possible to add 1-30 per cent by weight, relative to the diol, of a saturated diol to the composition. This will result in a less high degree of crosslinking of the end product, which may be advantageous for some applications.

The diol may further consist of an unsaturated polyester with two hydroxyl terminal groups.

The isocyanate index, that is, the number of isocyanate groups relative to the number of hydroxyl groups, generally amounts to 0.6-1.3, and preferably to 0.8-1.1. At an isocyanate index of 1 the urethane obtained will theoretically have the maximum molecular weight.

The ethylenically unsaturated monomer may be chosen from, for instance, aromatic vinyl compounds, vinyl esters, vinyl nitriles and (meth)acrylate esters. Examples are styrene, $\alpha$-methyl styrene, p-methyl styrene, vinyl toluene and acrylic acid or methacrylic acid (hydroxy) esters of alcohols with 1 to 12 carbon atoms. Preferably use is made of styrene. Also suitable are mixtures of monomers, in particular of styrene and other monomers.

The urethane reaction can be accelerated by increasing the temperature or by using a catalyst, for instance dibutyl tin dilaurate.

The radical reaction can be initiated by radical initiators. These may be all customary initiators, for instance peroxides, such as hydroperoxides, ketone hydroperoxides and peresters. Examples are benzoyl peroxide, ditertiary butyl peroxide, cyclohexanone peroxide, tertiary butyl perbenzoate and tertiary butyl peroctoate. Use may also be made of photoinitiators that are sensitive to visible light or ultraviolet light.

The amount of radical initiator is generally 0.5 to 5 per cent by weight, calculated relative to the unsaturated components.

The radical reaction can be temperature or radiation initiated. Examples of radiation are $\alpha$, $\gamma$, electron, X-ray and light radiation, etc.

The radical reaction can be accelerated by means of an increase in the temperature, while further a conventional accelerator can be added, such as, for instance, a cobalt compound or an amine.

A second example of a system that can be used according to the invention is a process in which the first category consists of the reaction of a carboxylic acid and an epoxide and the second category of a radical reaction of ethylenically unsaturated compounds. This can for instance be achieved with a mixture consisting of:

1) an unsaturated dicarboxylic acid or dicarboxylic acid anhydride
2) a di-epoxide, and
3) an ethylenically unsaturated monomer.

Examples of such di-epoxides are: diglycidyl ether, (di)glycidyl ether(s) of polyols or polyphenols, such as diethylene glycol, dipropylene glycol, polypropylene glycols with a molecular weight of up to about 2000 Dalton, bisphenol A, tetrabromo bisphenol A, hydrogenated bisphenol A, novolaks, etc.

The ethylenic monomer may be the same as the ethylenically unsaturated monomer as described for the first example above.

A third example of a system that can be used according to the invention is a mixture consisting of:

1) a monomer with an ethylenical unsaturation and an isocyanate reactive group, such as an hydroxyl group,
2) an ethylenically unsaturated monomer, and
3) a polyisocyanate.

The first component may be, for instance, an hydroxyalkyl (meth)acrylate, such as hydroxyethyl methacrylate.

The second component may be an ethylenic unsaturation as described above.

The third component may be a polyisocyanate as described above.

The mixture according to the third example can be reacted by first reacting the first component with the second component via a radical reaction. The urethane reaction can take place afterwards, after the mixture

has meanwhile been spun.

Any other combination fitting the description in the preamble of this specification can be chosen, and therefore the invention is not limited to the above examples.

It is possible to add further polymers to the mixture in order to realize certain product properties. These polymers may be miscible or immiscible with the monomers used and/or they may have functional groups that can react with at least a part of the functional groups of one or more of the monomers or of the polymer formed.

If desired, additives such as short glass fibres, pigment, stabilizers such as antioxidants and UV stabilizers, and fillers such as talc, mica, calcium carbonate, aluminium or carbon black may be added to the mixture.

The films according to the invention can be applied for instance as flexible printed circuit boards and as flexible layers in tape automated bonding.

The fibres according to the invention can be applied in numerous fields. As these fibres consist of thermosetting material, they have special properties, such as good mechanical properties, good transparency and flame retardancy. They may for instance be suitable for use as optical fibres.

The invention will be elucidated on the basis of the following examples, without being limited thereto.

## Example I

An amount of resin mixture of the following composition was introduced into a flask:

| | |
|---|---|
| 32.5 g | UP-1 |
| 12.5 g | HBA |
| 5 g | styrene |
| 18.12 g | H-MDI |
| 2 g | Darocure 1173$^R$ |
| 0.015 g | DBTDA |
| 70.13 g | total |

UP-1 is an unsaturated polyester resin based on the reaction product of
207.13 g hydrogenated bisphenol A
329.11 g neopentyl glycol
107.02 g ethylene glycol
517.26 g fumaric acid
HBA is 4-hydroxy butyl acrylate
HMDI is methylene dicyclohexyl-4,4′-diisocyanate
Darocure$^R$ 1173 is a photoinitiator.
DBTDA is a urethane catalyst: dibutyl tin diacetate.

The UP-1 was heated to 100°C and then added to the styrene and HBA. Subsequently the other components were added and mixing was effected by means of a stirrer.

The composition was deaerated in a vacuum stove and stored at room temperature for 24 hours.

Subsequently the composition was spun into a fibre at 20°C and passed through a transparent tube filled with an N, countercurrent. The fibre was radiated with UV light through the wall of the tube. After this, the fibre was wound on a bobbin.

The Young's modulus (E), the yield stress $\sigma_v$ and the elongation at break ($\varepsilon$) of the fibre were measured using a Zwick Tensile Tester with fibre clamps. The original fibre length was 50 cm, the crosshead speed 5 cm/min. From the stress/strain curve measured the E modulus, $\sigma_v$ and $\varepsilon$ were determined. The values found were 1.2 GPa, 30 MPa and 35%, respectively. This implies that the fibre was tough. The fibre is found to have good optical properties.

## Example II

The process of Example I was repeated, but now the spun fibre was additionally passed through an oven in between UV radiation and winding. The oven temperature was 150°C and the fibre's residence time a few seconds. The resulting fibre had a good windability and was not at all tacky. The fibre of Example II was also tough and also proves to have good optical properties.

Example III

The process of Example I was repeated with the following resin composition

| | | |
|---|---|---|
| 32.5 | g | UP-2 |
| 12.5 | g | HBA |
| 5 | g | styrene |
| 20.17 | g | H-MDI |
| 2.5 | g | Darocure 1173R |
| 0.015 | g | DBDTA |
| 72.69 | g | total |

UP-2 is an unsaturated polyester resin based on the reaction product of:
185.65 g hydrogenated bisphenol A
249.39 g neopentyl glycol
73.85 ethylene glycol
143.27 g adipic acid
265.59 g fumaric acid
The fibre was tack-free.
After UV curing and thermal post-curing at 150°C the mechanical properties were: E = 0.8 GPa, $\sigma_v$ = 20 MPa and $\varepsilon$ = 20%, which implied that this fibre, too, was tough. The fibre also possessed good optical properties.

Example IV

An amount of resin mixture of the following composition was introduced into a flask:

| | | |
|---|---|---|
| 200.0 | g | UP-3 |
| 4.0 | g | IrgacureR 651 |
| 0.02 | g | dibutyltindiacetaat (DBTDA) |
| 48.4 | g | Isonate R M143 |
| 252.4 | g | total |

UP-3 is an unsaturated polyester resin based on the reaction product of
161 g fumaric acid
96 g propoxylated bisphenol A
793 g ethoxylated bisphenol A
and dissolved in 538 g of styrene.
Irgacure 651R is a photoinitator, DBTDA is a urethane catalyst, IsonateR M143 is liquefied pure methylene diisocyanate.

The UP-3 was mixed by stirring at room temperature with the IrgacureR en the DBTDA. Subsequently the IsonateR was added and the composition was mixed by stirring again.

The composition was extruded then at 20°C into a film and passed through a transparent box in which an $N_2$ countercurrent was maintained. The film was radiated with UV light through the wall of the box. After this the film was wound on a bobbin and thermally cured at 120°C in an $N_2$ environment.

The Young's modulus (E), the yield stress $\sigma_v$ and the elongation at break ($\varepsilon$) of the film were measured using a Zwick Tensile Tester with film clamps. A film sample having a length between the clamps of 15 mm and a width of 4 mm was used. The crosshead speed was 1.3 mm/min. From the stress/strain curve measured the E modulus, $\sigma_v$ and $\varepsilon$ were determined. The values found were 2.6 GPa, 82 MPa and 5%, respectively. This implies that the film has a high strength and good flexibility.

Example V

An amount of resin mixture of the following composition was introduced into a flask:

| | | |
|---|---|---|
| 197.2 | g | VE-1 |
| 3.5 | g | Irgacure$^R$ 651 |
| 0.01 | g | dibutyltindiacetaat (DBTDA) |
| 77.6 | g | Isonate$^R$ M342 |
| 278.3 | g | total |

VE-1 is vinylester based on the reaction product of zie D:
682 g diglycidyl ether of bisphenol A
308 g methacrylic acid
and dissolved in 429 g of styrene.
Irgacure 651$^R$ is a photoinitator, DBTDA is a urethane catalyst, Isonate$^R$ M342 is a difunctional modified methylene diisocyanate.

The VE-1, the Irgacure$^R$ and the DBTDA were mixed by stirring at room temperature. Subsequently the Isonate$^R$ was added and the composition was mixed by stirring again.

The composition was extruded then at 20°C into a film and passed through a transparent box in which an $N_2$ countercurrent was maintained. The film was radiated with UV light through the wall of the box. After this the film was wound on a bobbin and thermally cured at 200°C in an $N_2$ environment.

The Young's modulus (E), the yield stress $\sigma_v$ and the elongation at break ($\varepsilon$) of the film were measured using a Zwick Tensile Tester with film clamps. A film sample having a length between the clamps of 15 mm and a width of 4 mm was used. The crosshead speed has 1.3 mm/min. From the stress/strain curve measured the E modulus, $\sigma_v$ and $\varepsilon$ were determined. The values found were 2.0 GPa, 80 MPa and 6%, respectively. This implies that the film has a high strength and good flexibility.

## Claims

1. Process for the preparation of a thermosetting elongated object by at least partly polymerizing a mixture of precursors for thermosetting resins and subsequently spinning and finally crosslinking the mixture, characterized in that the process comprises the following successive steps:
   i) a mixture is composed that consists of
      1) a first monomer possessing a number of functional groups of which one part falls in a first category and another part falls in a second category, a functional group of the first category not reacting with a functional group of the second category, and the monomer being essentially di-functional as regards the first category,
      2) a second monomer possessing essentially two functional groups that fall in the first category,
      3) a third monomer possessing one or more functional groups with a divalent functionality that fall in the second category;
   ii) the first monomer is reacted with the second monomer, yielding a virtually linear polymer;
   iii) the mixture is spun into an elongated object;
   iv) the virtually linear polymer is reacted with the third monomer.

2. Process according to claim 1, characterized in that the categories are chosen from the group consisting of the following reaction types:
   the reaction of isocyanates with hydroxyl groups
   the reaction of isocyanates with amines
   the reaction of isocyanates with epoxies
   the reaction of epoxies with acids
   the reaction of acids or acid anhydrides with alcohols
   the reaction of acids or acid anhydrides with oxazolines, and
   the reaction of several ethylenic unsaturations.

3. Process according to either of claims 1 and 2, characterized in that during the reaction in step ii the reaction of step iv is inhibited to such an extent that it does not or hardly take place.

4. Process according to any one of claims 1-3, characterized in that the mixture further contains 1-5 per cent by weight, relative to the mixture, of a tri- or higher-functional monomer.

5. Process according to any one of claims 1-4, characterized in that the first monomer has a functionality in the second category of at least two.

6. Process according to any one of claims 1-5, characterized in that the second monomer also has a functionality of at least one in the second category.

7. Process according to any one of claims 1-6, characterized in that the functional groups in the first category of the second monomer are complementary with the functional groups in the first category of the first monomer.

8. Process according to any one of claims 1-7, characterized in that the first category consists of the reaction of an hydroxyl group with an isocyanate and the second category of a radical reaction of ethylenically unsaturated bonds.

9. Process according to claim 8, characterized in that the first monomer is a diol with at least one ethylenic unsaturation and the second monomer is a polyisocyanate and the third monomer is an ethylenically unsaturated monomer.

10. Process according to any one of claims 1-7, characterized in that the first category consists of a reaction of a carboxylic acid and an epoxide and the second category consists of a radical reaction of ethylenically unsaturated bonds.

11. Process according to claim 10, characterized in that the first monomer is an unsaturated dicarboxylic acid or carboxylic acid anhydride and the second monomer is a di-epoxide and the third monomer is an ethylenically unsaturated monomer.

12. Elongated object obtainable by a process according to any one of claims 1-11.

13. Process and/or elongated object as wholly or partly described in the preamble of this specification and/or the examples.